# EUROPÄISCHE PATENTANMELDUNG

(11) **EP 4 815 715 A1**
(43) Veröffentlichungstag der Anmeldung: **30.09.2026**
(21) Anmeldenummer: 26166255.5
(22) Anmeldetag: 19.03.2026
(51) Int. Cl.: H10W 90/00, H10W 40/25, H10W 40/77, H10W 74/10, H05K 7/20, H10W 40/20, H10W 70/40

(54) **LEISTUNGSMODUL**

(30) Priorität: 26.03.2025 DE 102025111667
(71) Anmelder: Volkswagen Aktiengesellschaft, 38440 Wolfsburg (DE)
(72) Erfinder: Wilke, Robert, 38440 Wolfsburg (DE); Bayer, Christoph Friedrich, 38440 Wolfsburg (DE); Otto, Alexander, 38440 Wolfsburg (DE); Zeinel, Denis, 38440 Wolfsburg (DE); Pihale, Sven, 38440 Wolfsburg (DE); Kraft, Silke, 38440 Wolfsburg (DE); Dedeleit, Lukas, 38440 Wolfsburg (DE)

(57) **Zusammenfassung**

Die Erfindung betrifft ein Leistungsmodul (1), wobei das Leistungsmodul (1) einen ersten Träger (2) und einen zweiten Träger (8) aufweist, die von mindestens einer Isoliermasse (17) umhüllt sind, wobei der erste Träger (2) eine Keramik (3) mit einer strukturierten Metallisierung (4) auf einer Oberseite aufweist, wobei auf Strukturen (5) der strukturierten Metallisierung (4) Leistungshalbleiter (7) angeordnet sind, wobei der zweite Träger (8) als Leiterplatte (9) ausgebildet ist, auf der mindestens Gate-Treiber (10) für die Leistungshalbleiter (7) auf dem ersten Träger (2) angeordnet sind, wobei der zweite Träger (8) über Abstandshalter (11) oberhalb des ersten Trägers (2) angeordnet ist, wobei die Abstandshalter (11) auf Strukturen (5) der strukturierten Metallisierung (4) aufgebracht sind, auf denen keine Leistungshalbleiter (7) angeordnet sind und/oder direkt auf der Keramik (3) angeordnet sind.

## Beschreibung

Die Erfindung betrifft ein Leistungsmodul.

Leistungsmodule umfassen typischerweise mehrere Leistungshalbleiter, die auf einem Träger angeordnet sind. Beispielsweise bilden die Leistungshalbleiter eine Halbbrückenschaltung eines Wechselrichters. Dabei fließen verhältnismäßig große Ströme und es werden Spannungen von beispielsweise 100 V - 800 V verwendet. Zum Schutz der Leistungshalbleiter und den elektrischen Verbindungen ist es bekannt, dass das Leistungsmodul mit einer Isoliermasse umhüllt ist, wozu dieses mit einer Vergussmasse vergossen wird oder mit einer Moldmasse (Transfermold) umspritzt wird. Dabei weist das Leistungsmodul von außen zugängliche Kontakte auf, die auch nach der Umhüllung der Isoliermasse zugänglich sind. Dies sind beispielsweise Lastanschlüsse, um DC+, DC- und einen Phasenanschluss anzuschließen. Weiter werden Signalpins aus dem Leistungsmodul herausgeführt, um beispielsweise Steuersignale für die Leistungshalbleiter zur Verfügung zu stellen sowie Sensorsignale herauszuführen. Dabei ist beispielsweise ein zweiter Träger mit Gate-Treibern oberhalb oder neben dem Leistungsmodul angeordnet. Aufgrund der hohen Wärmeentwicklung der Leistungshalbleiter weist der erste Träger eine Keramik auf, auf deren Oberseite eine strukturierte Metallisierung aufgebracht ist. Die Strukturierung erfolgt beispielsweise mittels Ätzen, sodass elektrisch getrennte Strukturen entstehen, auf denen die Leistungshalbleiter angeordnet sind. Die Verbindung zwischen den Leistungshalbleitern kann dann mittels Bonddrähten, Bondbändchen, Clips oder Leadframes erfolgen. Vorzugsweise weist die Keramik auch an der Unterseite eine Metallisierung auf, über die dann das Leistungsmodul mit einem Kühlkörper oder einer Kühleinrichtung verbunden werden kann, um die Verlustwärme der Leistungshalbleiter abzuführen.

Unter Gesichtspunkten der Kompaktheit und möglichst kurzer Leitungswege wäre es wünschenswert, den zweiten Träger mit seinen Bauteilen in das Leistungsmodul zu integrieren. Andererseits stellt die große Wärmeentwicklung der Leistungshalbleiter ein Problem für die Bauelemente auf dem zweiten Träger dar.

Der Erfindung liegt das technische Problem zugrunde, ein kompaktes Leistungsmodul zu schaffen, wobei thermische Probleme reduziert werden.

Die Lösung des technischen Problems ergibt sich durch ein Leistungsmodulmit den Merkmalen des Anspruchs 1. Weitere vorteilhafte Ausgestaltungen der Erfindung ergeben sich aus den Unteransprüchen.

Das Leistungsmodul weist einen ersten Träger und einen zweiten Träger auf, die von mindestens einer Isoliermasse umhüllt sind. Die mindestens eine Isoliermasse kann eine Vergussmasse (z.B. Silikongel) und/oder ein Transfermold (z.B. Epoxidharz) sein. Der erste Träger weist eine Keramik mit einer strukturierten Metallisierung auf einer Oberseite auf, wobei auf Strukturen der strukturierten Metallisierung Leistungshalbleiter angeordnet sind. Der zweite Träger ist als Leiterplatte ausgebildet, auf der mindestens Gate-Treiber für die Leistungshalbleiter auf dem ersten Träger angeordnet sind. Weitere aktive oder passive Bauelemente wie Widerstände oder Kondensatoren können auf der Leiterplatte angeordnet sein. Die Leiterplatte kann insbesondere als mehrlagige Leiterplatte ausgebildet sein. Der zweite Träger ist über Abstandshalter oberhalb des ersten Trägers angeordnet, wobei die Abstandshalter auf Strukturen der strukturierten Metallisierung aufgebracht sind, auf denen keine Leistungshalbleiter angeordnet sind. Alternativ oder ergänzend sind die Abstandhalter direkt auf der Keramik angeordnet. Ergänzend bedeutet dabei, dass mindestens ein Abstandshalter auf einer Struktur und mindestens ein Abstandshalter auf der Keramik angeordnet ist. Hierdurch wird der zweite Träger thermisch an den ersten Träger gekoppelt, sodass Wärme vom zweiten Träger an die Keramik abgeführt wird. Von der Keramik kann dann die Wärme über eine Kühleinrichtung oder einen Kühlkörper abgeführt werden. Dabei erfolgt die thermische und mechanische Ankopplung an Stellen des ersten Trägers, die selbst keiner großen Wärmeentwicklung ausgesetzt sind, sodass verhindert wird, dass nennenswert Wärme vom ersten Träger in den zweiten Träger eingekoppelt wird. Die Abstandshalter weisen dabei vorzugsweise eine hohe Wärmeleitfähigkeit auf.

In einer Ausführungsform bestehen die Abstandshalter aus Kupfer, Aluminium oder AlSiC, die alle eine sehr gute Wärmeleitfähigkeit aufweisen. Dabei wird vorzugsweise das gleiche Metall verwendet, das auch für die strukturierte Metallisierung verwendet wird. Der Vorteil von AlSiC ist, dass es eine ähnliche Wärmeausdehnung wie die Keramik aufweist, sodass thermische Spannungen reduziert werden können. Da Kupfer und Aluminium auch eine hohe elektrische Leitfähigkeit aufweisen, können die Abstandshalter in einigen Ausführungsformen auch als elektrische Verbindung zwischen erstem Träger und zweitem Träger verwendet werden. Wenn dies hingegen nicht gewünscht ist, muss der zweite Träger an der Unterseite entsprechend isoliert sein und/oder zwischen Abstandshalter und zweitem Träger wird eine elektrischnichtleitfähige Wärmepaste aufgebracht.

Alternativ oder ergänzend wird mindestens eine elektrische Verbindung zwischen dem ersten Träger und dem zweiten Träger über mindestens einen Signalpin realisiert.

Alternativ oder ergänzend erfolgt mindestens eine elektrische Verbindung zwischen dem ersten Träger und dem zweiten Träger über mindestens einen Bonddraht oder Bondbändchen. Vorzugsweise weist der zweite Träger hierzu Durchbrüche auf, durch die die Bonddrähte und/oder Bondbändchen geführt sind. Ein weiterer Vorteil der Durchbrüche ist, dass sich die Isoliermasse besser verteilt.

In einer weiteren Ausführungsform ist die Laststromleitung ausschließlich über den ersten Träger geführt. Hierdurch ist die elektrische Isolierung zwischen den Bauelementen auf dem zweiten Träger vereinfacht und es wird weniger Wärme in den zweiten Träger eingekoppelt.

In einer alternativen Ausführungsform erfolgt die Laststromleitung teilweise über den zweiten Träger, wobei von außen zugängliche Lastanschlüsse (z.B. DC+, DC- und AC bei einer Halbbrücke) ausschließlich am zweiten Träger angeordnet sind.

Die Erfindung wird nachfolgend anhand bevorzugter Ausführungsbeispiele näher erläutert. Die Figuren zeigen:
- Fig. 1: eine schematische Darstellung eines Leistungsmoduls in einer ersten Ausführungsform und
- Fig. 2: eine schematische Darstellung eines Leistungsmoduls in einer zweiten Ausführungsform.

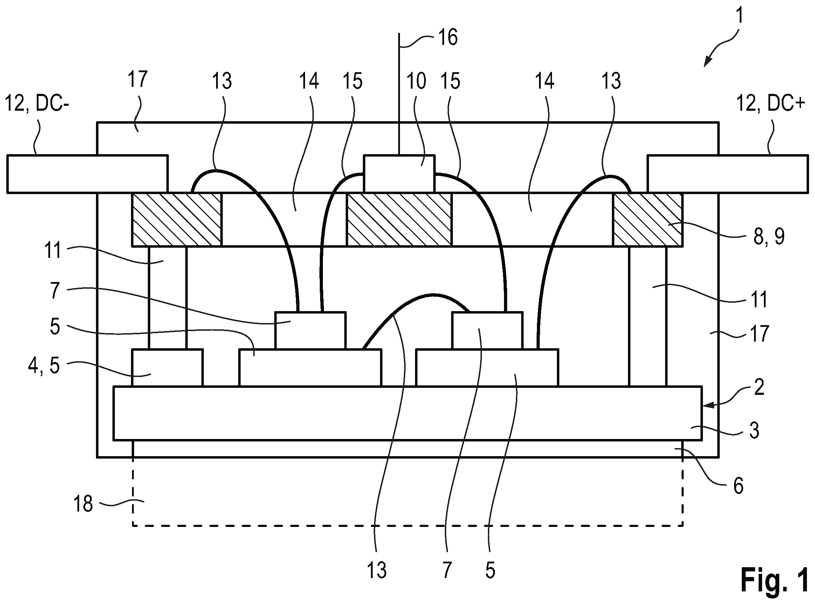

In der Fig. 1 ist stark schematisch ein Leistungsmodul 1 in einer Schnittdarstellung gezeigt. Das Leistungsmodul 1 weist einen ersten Träger 2 auf. Der erste Träger 2 weist eine Keramik 3 auf, auf deren Oberseite eine strukturierte Metallisierung 4 mit Strukturen 5 angeordnet ist. Weiter weist der erste Träger 2 an der Unterseite eine weitere Metallisierung 6 auf. Die Metallisierungen 4, 6 sind beispielsweise aus Kupfer oder Aluminium. Beispielsweise ist der erste Träger als IMS (Isolated Metal Substrate), AMB (Active Metal Brazing) oder DBC (Direct Bonded Copper) ausgebildet. Auf einigen der Strukturen 5 sind Leistungshalbleiter 7 angeordnet, die beispielsweise als MOSFETs, IGBTs oder GaN HEMTs ausgebildet sind. Die MOSFETs können beispielsweise als Si- oder SiC-MOSFETs ausgebildet sein. Für die nachfolgenden Erläuterungen wird davon ausgegangen, dass die Leistungshalbleiter als MOSFETs ausgebildet sind, wobei auf deren Unterseite ein Drain-Anschluss ist und auf der Oberseite der Source- und Gate-Anschluss (sowie gegebenenfalls Kelvin-Source-Anschlüsse) angeordnet sind. Weiter weist das Leistungsmodul 1 einen weiteren Träger 8 auf, der als Leiterplatte 9 ausgebildet ist. Die Leiterplatte 9 ist vorzugsweise als mehrlagige Leiterplatte ausgebildet, die mehrere elektrisch isolierte Metalllagen aufweist, die hier aus Übersichtsgründen nicht dargestellt sind. Auf dem zweiten Träger 8 ist mindestens ein Gate-Treiber 10 angeordnet, der Steuersignale für die beiden Leistungshalbleiter 7 erzeugt. Dabei können mehrere Gate-Treiber 10 vorhanden sein. Zusätzlich können weitere aktive und/oder passive Bauelemente auf dem zweiten Träger 8 angeordnet sein. Zwischen dem ersten Träger 2 und dem zweiten Träger 8 sind Abstandshalter 11 angeordnet. Die Abstandshalter 11 weisen beispielsweise eine quaderförmige oder zylindrische Struktur auf und sind beispielsweise aus Kupfer, Aluminium oder AlSiC. Die Abstandshalter 11 dienen zur Positionierung des zweiten Träger 8 oberhalb des ersten Trägers 2 sowie zur thermischen Anbindung. Dabei sind die Abstandshalter 11 auf Strukturen 5 der strukturierten Metallisierung 4 angeordnet, auf denen keine Leistungshalbleiter 7 angeordnet sind oder diese sind direkt auf der Keramik 3 angeordnet. Soll zusätzlich auch eine elektrische Verbindung realisiert werden, so sind die Abstandshalter 11 auf einer Struktur 5 angeordnet und aus Kupfer oder Aluminium ausgebildet, wobei an der Leiterplatte 9 eine Metalllage kontaktiert wird. Auf der Leiterplatte 9 sind weiter Lastanschlüsse 12 angeordnet (z.B. Clips oder Leadframes), die beispielsweise zum Anschluss von DC- und DC+ dienen. Hierzu ist der Source-Kontakt der linken Leistungshalbleiter 7 über einen dicken Bonddraht 13 oder mehrere Bonddrähte mit einer Metalllage der Leiterplatte 9 verbunden. Dabei sind die Bonddrähte 13 durch Durchbrüche 14 in der Leiterplatte 9 geführt. Entsprechend sind auch die Bonddrähte 15 von dem oder den Gate-Treibern 10 durch die Durchbrüche 14 geführt. Dabei ist ein Signalkontakt 16 am Gate-Treiber 10 angeordnet, über den dieser beispielsweise Steuersignale von einem Mikroprozessor erhält. Das Leistungsmodul 1 ist mit einer Isoliermasse 17 umhüllt. Die Isoliermasse 17 kann dabei in einem Schritt das Leistungsmodul 1 umhüllen. Der Prozess kann aber auch mehrstufig sein, wobei dann auch verschiedene Isoliermassen 17 zur Anwendung kommen können. Bei dieser Ausführungsform sind alle von außen zugänglichen Kontakte (Lastanschlüsse 12, Signalkontakte 16) mit der Leiterplatte 9 verbunden. Die Metallisierung 6 kann dann mit einem Kühlkörper 18 verbunden werden.

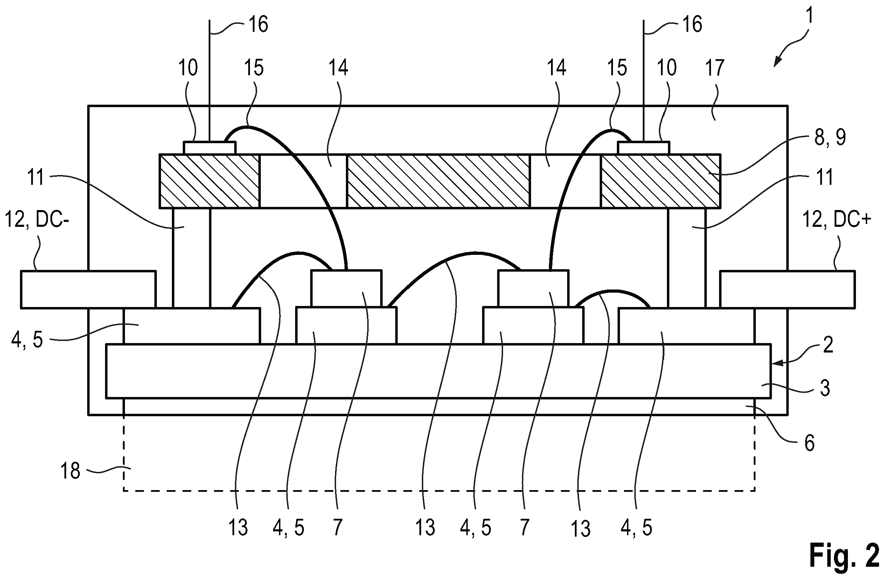

In der Fig. 2 ist eine alternative Ausführungsform für ein Leistungsmodul 1 dargestellt, wobei gleiche Elemente mit gleichen Bezugszeichen versehen sind. Der wesentliche Unterschied zur Ausführungsform gemäß Fig. 1 ist, dass die Laststromleitung ausschließlich über den ersten Träger 2 erfolgt. Entsprechend sind die Lastanschlüsse 12 mit Strukturen 5 der strukturierten Metallisierung 4 verbunden. Die elektrische Verbindung zwischen den Leistungshalbleitern 7 sowie von den Leistungshalbleitern 7 zu Strukturen 5 erfolgt über dicke Bonddrähte 13 bzw. einer Vielzahl von Bonddrähten oder Bondbändchen. Alternativ können einzelne oder alle Verbindungen in der Laststromleitung auch mittels Clips oder Leadframes (Metallbleche) erfolgen. Durch diese Trennung ist der Wärmeeintrag in den zweiten Träger 8 geringer.

### Bezugszeichenliste

- 1: Leistungsmodul
- 2: erster Träger
- 3: Keramik
- 4: strukturierte Metallisierung
- 5: Struktur
- 6: weitere Metallisierung
- 7: Leistungshalbleiter
- 8: zweiter Träger
- 9: Leiterplatte
- 10: Gate-Treiber
- 11: Abstandshalter
- 12: Lastanschluss
- 13: Bonddraht
- 14: Durchbruch
- 15: Bonddraht
- 16: Signalkontakt
- 17: Isoliermasse
- 18: Kühlkörper

## Patentansprüche

1. Leistungsmodul (1), wobei das Leistungsmodul (1) einen ersten Träger (2) und einen zweiten Träger (8) aufweist, die von mindestens einer Isoliermasse (17) umhüllt sind, wobei der erste Träger (2) eine Keramik (3) mit einer strukturierten Metallisierung (4) auf einer Oberseite aufweist, wobei auf Strukturen (5) der strukturierten Metallisierung (4) Leistungshalbleiter (7) angeordnet sind, wobei der zweite Träger (8) als Leiterplatte (9) ausgebildet ist, auf der mindestens Gate-Treiber (10) für die Leistungshalbleiter (7) auf dem ersten Träger (2) angeordnet sind, wobei der zweite Träger (8) über Abstandshalter (11) oberhalb des ersten Trägers (2) angeordnet ist, wobei die Abstandshalter (11) auf Strukturen (5) der strukturierten Metallisierung (4) aufgebracht sind, auf denen keine Leistungshalbleiter (7) angeordnet sind und/oder direkt auf der Keramik (3) angeordnet sind.

2. Leistungsmodul (1) nach Anspruch 1, **dadurch gekennzeichnet, dass** die Abstandshalter (11) aus Kupfer, Aluminium oder AlSiC bestehen.

3. Leistungsmodul (1) nach Anspruch 1 oder 2, **dadurch gekennzeichnet, dass** mindestens eine elektrische Verbindung zwischen dem ersten Träger (2) und dem zweiten Träger (8) über mindestens einen Abstandshalter (11) erfolgt.

4. Leistungsmodul (1) nach einem der vorangegangenen Ansprüche, **dadurch gekennzeichnet, dass** mindestens eine elektrische Verbindung zwischen dem ersten Träger (2) und dem zweiten Träger (8) über mindestens einen Signalpin folgt.

5. Leistungsmodul (1) nach einem der vorangegangenen Ansprüche, **dadurch gekennzeichnet, dass** mindestens eine elektrische Verbindung zwischen dem ersten Träger und dem zweiten Träger über mindestens einen Bonddraht (13, 15) oder Bondbändchen erfolgt.

6. Leistungsmodul (1) nach Anspruch 5, **dadurch gekennzeichnet, dass** der zweite Träger (8) Durchbrüche (14) aufweist, durch die die Bonddrähte (13, 15) und/oder Bondbändchen geführt sind.

7. Leistungsmodul (1) nach einem der vorangegangenen Ansprüche, **dadurch gekennzeichnet, dass** die Laststromleitung ausschließlich über den ersten Träger (2) geführt ist.

8. Leistungsmodul (1) nach einem der Ansprüche 1 bis 6, **dadurch gekennzeichnet, dass** die Laststromleitung teilweise über den zweiten Träger (8) erfolgt, wobei von außen zugängliche Lastanschlüsse (12) ausschließlich am zweiten Träger (8) angeordnet sind.
